# FASCICULE DE BREVET EUROPEEN

(11) **EP 1 382 074 B1**
(45) Date de publication et mention de la délivrance du brevet: **10.11.2010**
(21) Numéro de dépôt: 02726265.8
(22) Date de dépôt: 18.04.2002
(51) Int. Cl.: H01L 33/26

(54) **DISPOSITIF ELECTROLUMINESCENT A EXTRACTEUR DE LUMIERE**
ELEKTROLUMINESZENTE VORRICHTUNG MIT LICHTAUSKOPPELUNG
ELECTROLUMINESCENT DEVICE WITH LIGHT EXTRACTOR

(30) Priorité: 26.04.2001 FR 0105652
(43) Date de publication de la demande: 21.01.2004
(73) Titulaire: CENTRE NATIONAL DE LA RECHERCHE SCIENTIFIQUE (CNRS), 75794 Paris Cedex 16 (FR); Ecole Polytechnique, 91128 Palaiseau Cedex (FR)
(72) Inventeur: RATTIER, Maxime, F-75014 Paris (FR); BENISTY, Henri, F-91120 Palaiseau (FR); WEISBUCH, Claude, F-75013 Paris (FR)
(74) Mandataire: Ramey, Daniel
(86) Numéro de dépôt international: PCT/FR2002/001341
(87) Numéro de publication internationale: WO 2002/089218

(56) Documents cités:
- RATTIER M ET AL: "Ultra-thin, laterally injected light-emitting diodes-the role of photonic crystals for light extraction" CONFERENCE DIGEST. 2000 CONFERENCE ON LASERS AND ELECTRO-OPTICS EUROPE (CAT. NO.00TH8505), CONFERENCE DIGEST. 2000 CONFERENCE ON LASERS AND ELECTRO-OPTICS EUROPE, NICE, FRANCE, 10-15 SEPT. 2000, page 1 pp. XP002187482 2000, Piscataway, NJ, USA, IEEE, USA ISBN: 0-7803-6319-1
- ERCHAK A A ET AL: "ENHANCED COUPLING TO VERTICAL RADIATION USING A TWO-DIMENSIONAL PHOTONIC CRYSTAL IN A SEMICONDUCTOR LIGHT-EMITTING DIODE" APPLIED PHYSICS LETTERS, AMERICAN INSTITUTE OF PHYSICS. NEW YORK, US, vol. 78, no. 5, 29 janvier 2001 (2001-01-29), pages 563-565, XP000994474 ISSN: 0003-6951
- DELBEKE D ET AL: "Electrically pumped photonic crystal micro-cavity light emitting diodes" 1999 DIGEST OF THE LEOS SUMMER TOPICAL MEETINGS: NANOSTRUCTURES AND QUANTUM DOTS/WDM COMPONENTS/VCSELS AND MICROCAVATIES/RF PHOTONICS FOR CATV AND HFC SYSTEMS (CAT. NO.99TH8455), 1999 DIGEST OF THE LEOS SUMMER TOPICAL MEETINGS, SAN DIEGO, CA, USA, 26, pages III71-III72, XP002187483 1999, Piscataway, NJ, USA, IEEE, USA ISBN: 0-7803-5633-0
- GOURLEY P L ET AL: "OPTICAL PROPERTIES OF TWO-DIMENSIONAL PHOTONIC LATTICES FABRICATED AS HONEYCOMB NANOSTRUCTURES IN COMPOUND SEMICONDUCTORS" APPLIED PHYSICS LETTERS, AMERICAN INSTITUTE OF PHYSICS. NEW YORK, US, vol. 64, no. 6, 7 février 1994 (1994-02-07), pages 687-689, XP000422868 ISSN: 0003-6951
- BORODITSKY M ET AL: "Light extraction from optically pumped light-emitting diode by thin-slab photonic crystals" APPLIED PHYSICS LETTERS, 23 AUG. 1999, AIP, USA, vol. 75, no. 8, pages 1036-1038, XP000868166 ISSN: 0003-6951
- ZOOROB M E ET AL: "COMPLETE PHOTONIC BANDGAPS IN 12-FOLD SYMMETRIC QUASICRYSTALS" NATURE, MACMILLAN JOURNALS LTD. LONDON, GB, vol. 404, no. 6779, 2000, pages 740-743, XP000914814 ISSN: 0028-0836
- DAVID S ET AL: "Wide angularly isotropic photonic bandgaps obtained from two-dimensional photonic crystals with Archimedean-like tilings" OPTICS LETTERS, 15 JULY 2000, OPT. SOC. AMERICA, USA, vol. 25, no. 14, pages 1001-1003, XP002187484 ISSN: 0146-9592 cité dans la demande
- MISHA BORODITSKY, ELL YABLANOVITCH: "Photonic crystals boost light emission" PHYSICS WORLD, vol. 10, no. 7, 1 July 1997 (1997-07-01), - 31 July 1997 (1997-07-31) pages 25-36, Bristol and Philadelphia ISSN: 0953-8585

## Description

La présente invention concerne les dispositifs électroluminescents, tels que les diodes électroluminescentes.

Les diodes électroluminescentes (ou DEL) sont des dispositifs émetteurs de lumière qui sont de plus en plus utilisés en raison, notamment, de leur faible coût, de leur faible encombrement, de leur friabilité, de leur robustesse et de leur rendement élevé. Ces DELs sont notamment utilisées dans les domaines de l'affichage, de l'éclairage et de la signalisation lorsqu'elles émettent dans le spectre visible, ou dans le domaine de la commande à distance lorsqu'elles émettent dans l'infrarouge. Elles sont généralement réalisées à partir d'un matériau semi-conducteur, notamment de la famille des III-V, déposé sur un substrat, solidarisé à une embase, et relié à deux électrodes, l'ensemble étant logé dans un dôme en résine époxy.

On connaît, par le document M. Rattier et al.: « Ultra-thin, laterally injected light-emitting diodes- the role of photonic crystals for light extraction » Conf. digest 2000, Conference on lasers and electro-optics Europe, (cat. N°00TH8505). p.1, XP002187482, Piscataway, NJ, USA, IEEE, ISBN: 0-7803-6319-1, une diode électroluminescente à microcavité plane, dans laquelle des cristaux photoniques sont autour de la zone d'émission à une distance inférieure à la longueur d'absorption pour extraire la lumière guidée.

Afin d'améliorer le rendement de ces DELs, il a été récemment proposé (voir notamment le document US 5,405,710) de les réaliser sous la forme d'un empilement dans-lequel des moyens de génération d'électrons et de trous et des moyens de conversion de paires électron-trou en photons sont placés entre un miroir inférieur (réfléchissant), placé sur un substrat, et un miroir supérieur (semi-réfléchissant) parallèle au miroir inférieur et communiquant avec l'extérieur. Cependant, seuls parviennent à atteindre l'extérieur du dispositif les photons qui sont émis dans une direction sensiblement normale au plan du miroir supérieur et vers celui-ci, et les photons qui sont émis dans une direction sensiblement normale au plan du miroir inférieur et vers celui-ci, puis réfléchis vers le miroir supérieur. En conséquence, une partie non négligeable des photons produits ne parvient pas à l'extérieur du dispositif.

L'invention a pour but d'améliorer le rendement d'extraction des photons de ce type de dispositif électroluminescent.

Elle propose à cet effet un dispositif électroluminescent selon la revendication 1.

On entend ici par « longueur d'onde choisie », la longueur d'onde pic ou principale du spectre d'émission du dispositif électroluminescent.

Ainsi, une grande partie des photons qui sont confinés entre les miroirs, et qui parviennent au niveau des moyens d'extraction peuvent être dirigés vers l'extérieur du dispositif.

Cette structuration définit préférentiellement, sensiblement, un cristal ou quasi-cristal photonique formé de trous ou de colonnes qui constituent des éléments diffractants dont les dimensions sont typiquement de l'ordre de la longueur d'onde des photons dans le mode guidé.

Préférentiellement le quasi-cristai est un pavage de polygones convexes sensiblement jointifs et partageant chacune de leurs arêtes avec un unique voisin, la taille des arêtes étant par ailleurs sensiblement égale à une valeur moyenne choisie, à environ +/-15%.

Ce pavage peut se présenter sous de nombreuses formes, et notamment :
- présenter des proportions comparables de carrés et de triangles équilatéraux, ou de premiers et seconds losanges d'angles aux sommets différents, et dont les arêtes sont sensiblement de la même taille ;
- être construit par périodisation ou inflation de Stampfli d'un motif comportant un nombre choisi de triangles équilatéraux et de carrés, ou de premiers et seconds losanges d'angles aux sommets différents ;
- être construit par une distribution sensiblement aléatoire de proportions choisies de triangles équilatéraux et de carrés, ou de premiers et seconds losanges d'angles aux sommets différents.

Par ailleurs, quelle que soit la forme du pavage il peut être légèrement tordu de manière à entourer au moins en partie les moyens de génération et les moyens de conversion. Ce pavage peut également être courbé de manière à s'étendre sur au moins une partie d'une zone annulaire.

En outre, le pavage du quasi-cristal peut comporter une ou plusieurs lacunes de manière à former une structure de type amorphe, ce qui se traduit par l'absence d'un ou plusieurs éléments diffractants dans la structuration.

Selon encore une autre caractéristique de l'invention, le premier miroir est semi-réfléchissant et constitué par une interface entre une couche des moyens de génération et une couche d'un autre matériau, comme par exemple l'air ou l'époxy extérieur ou un matériau formant un substrat, tel que le verre, le GaP, le saphir, le carbure de silicium ou le rutile. Par ailleurs, le second miroir est préférentiellement constitué par un empilement de paires de couches de semiconducteur(s) ou d'oxyde(s), crûs, déposés ou formés in situ, formant un miroir distribué de Bragg. A cet effet, on peut notamment utiliser des matériaux semiconducteurs tels que le silicium, les composés à base de gallium, d'arsenic, d'aluminium, d'indium, d'azote, de phosphore et d'antimoine, ainsi que leurs alliages (par exemple GaAs, AlAs, GaAlAs, InGaAs et AlGAlnP). Pour ce qui concerne les oxydes, on peut utiliser notamment SiO₂, TiO₂. HfO₂, Ta₂O₅ et Al₂O₃. Par exemple, pour obtenir un miroir distribué très réfléchissant on peut former un empilement de couches alternées de GaAs et d'oxyde d'aluminium, de stoechiométrie proche de Al₂O₃, obtenu par oxydation latérale de couche d'AlGaAs comme décrit dans le document de J.M. Dallesasse, N. Holonyak Jr, A.R. Stugg, T.A. Richard et N. Elzein, Appll. Phys. Lett. Vol. 57 pp. 2844-2846, 1990. Dans une variante, le miroir très réfléchissant peut être réalisé par dépôt de métal, comme par exemple de l'or.

Une réalisation préférée consiste à associer un miroir très réfléchissant de type distribué (par exemple GaAs/AlOx) et un miroir semi-réfléchissant formé par une interface GaAs/air extérieur.

Dans une autre variante, les deux miroirs peuvent être de type distribué.

Les distances séparant les miroirs et les caractéristiques des matériaux qui les composent sont choisies de manière à définir préférentiellement une micro-cavité résonante, notamment de type Fabry-Pérot, ou une cavité anti-résonante aux longueurs d'onde des photons émis par les moyens de conversion.

Dans un mode de réalisation avantageux, les moyens de conversion et une partie au moins des moyens de génération sont constitués de matériaux choisis dans un groupe comprenant les matériaux organiques électroluminescents, tels que les polymères organiques, conjugués ou non, et les complexes organométalliques, tels que AlQ₃, et les semiconducteurs, tels que notamment le silicium, le gallium, l'aluminium, l'indium, l'azote, le phosphore, l'arsenic et l'antimoine, ainsi que leurs alliages.

Le dispositif selon l'invention, présenté ci-avant, trouve une application particulièrement intéressante lorsqu'il fait partie d'une diode électroluminescente.

D'autres caractéristiques et avantages de l'invention apparaîtront à l'examen de la description détaillée ci-après, et des dessins annexés, sur lesquels :
- la figure 1 est une vue en coupe très schématique d'une diode électroluminescente,
- la figure 2 est une vue en coupe très schématique d'un dispositif selon l'invention assurant l'émission de lumière dans une diode électroluminescente, et
- les figures 3A à 3G sont des vues schématiques illustrant des pavages de quasi-cristaux photoniques pouvant être utilisés dans un dispositif selon l'invention pour assurer l'extraction de photons.

Les dessins annexés sont, pour l'essentiel, de caractère certain. En conséquence, ils pourront non seulement servir à compléter l'invention, mais aussi contribuer à sa définition, le cas échéant.

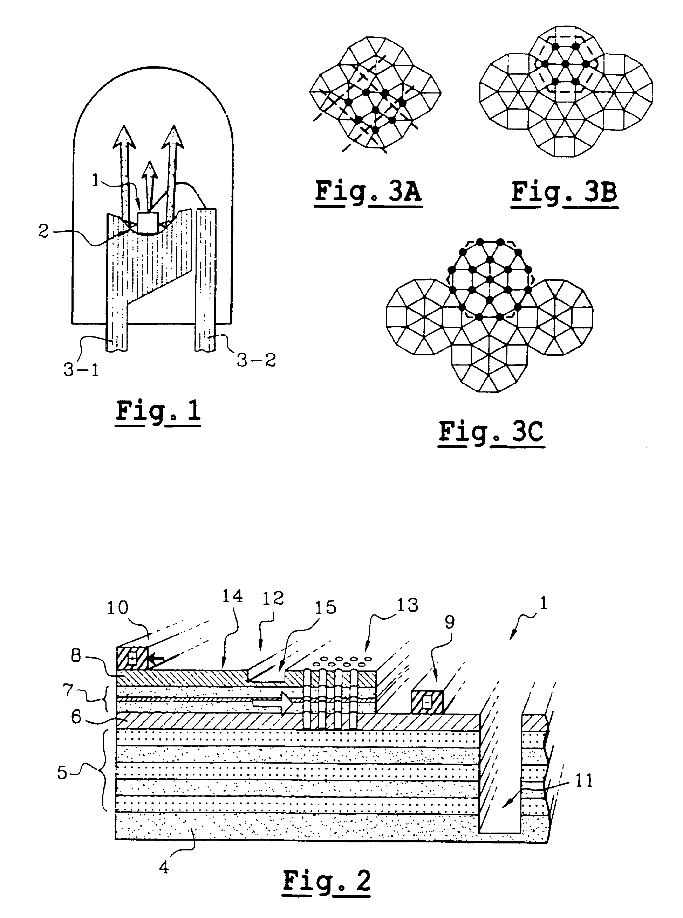

Dans la description qui suit, il sera fait référence à un dispositif électroluminescent faisant partie d'une diode électroluminescente (ou DEL), du type de celle illustrée sur la figure 1.

Plus précisément, la diode de la figure 1 est une diode de l'art antérieur comprenant un dispositif électroluminescent 1 placé dans un réflecteur 2, en forme de cuvette, et raccordé à deux broches 3-1 et 3-2 d'alimentation en courant, l'une 3-2 étant placée à un potentiel positif et l'autre 3-1 à un potentiel négatif, ou l'inverse, comme cela est bien connu de l'homme de l'art.

Comme indiqué dans l'introduction, le rendement d'extraction des photons, qui sont produits dans les dispositifs électroluminescents réalisés à l'aide de matériaux semi-conducteurs, est assez faible. Environ 5% des photons émis dans le matériau semi-conducteur peuvent être récupérés à l'extérieur, par la surface supérieure. Récemment (voir notamment le document US 5,405,710), la société LUCENT a proposé un perfectionnement aux dispositifs électroluminescents traditionnels. Il consiste à placer les moyens de conversion des paires électron/trou en photons entre deux miroirs qui définissent une micro-cavité résonante, de type Fabry-Pérot. Les photons qui sont émis vers le miroir supérieur, qui communique avec l'air extérieur, suivant une direction sensiblement perpendiculaire à ce miroir supérieur, jusqu'à un angle dit « angle critique » (bien connu de l'homme de l'art), parviennent à gagner l'extérieur du dispositif, et contribuent de ce fait à l'éclairement. De même, les photons qui sont émis vers le miroir inférieur suivant une direction sensiblement parallèle à la normale de ce miroir inférieur, à quelques degrés près, peuvent être réfléchis en direction du miroir supérieur et parvenir à l'extérieur pour contribuer à l'éclairement, comme cela est notamment décrit dans le document de H. Benisty, H. De Neve et C. Weisbuch, IEEE Journal of Quantum Electronics, vol. 34, pp. 1612-1631, 1998. L'Ecole Polytechnique Fédérale de Lausanne a également proposé une amélioration de ce type de cavité, basée sur un empilement optique particulier des moyens de conversion et des moyens de génération de porteurs, qui peut également servir de structure de départ à la présente invention. Avec une telle diode, il est possible d'atteindre des rendements de l'ordre de 30%.

En d'autres termes, environ 70% des photons qui sont produits par les moyens de conversion du dispositif électroluminescent sont perdus à l'intérieur de la structure. Parmi ces 70%, environ 20% partent vers le substrat sur lequel se trouve placé le miroir inférieur, et y sont absorbés, tandis que les 50% restants sont confinés entre les deux miroirs, c'est-à-dire juste sous la surface supérieure dans le cas où le miroir semi-réfléchissant est constitué d'une simple interface constituée d'une couche des moyens de génération de porteur et d'un matériau extérieur au dispositif, sous la forme d'un mode guidé qui se propage et arrive, pour une bonne partie, au bord de la structure où il est diffracté vers le substrat et donc absorbé.

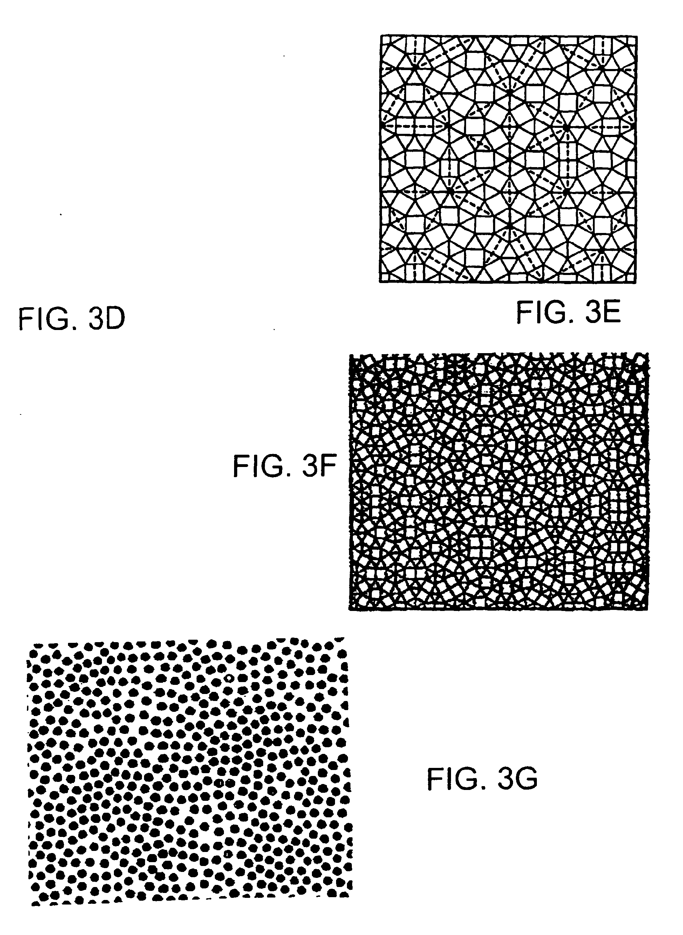

L'invention a donc pour but d'améliorer la situation en offrant un dispositif électroluminescent muni de moyens d'extraction de photons qui va être décrit ci-après en référence aux figures 2 et 3.

Dans l'exemple illustré sur la figure 2, le dispositif selon l'invention comporte, tout d'abord, un substrat 4 auquel est solidarisé un miroir inférieur 5, réfléchissant. La face supérieure de ce miroir inférieur 5 est solidarisée à une couche 6, destinée à générer des porteurs, tels que des électrons.

La face supérieure de cette couche 6 est solidarisée à des moyens de conversion de paires électron/trou en photons 7. La face supérieure de ces moyens de conversion 7 est solidarisée à une seconde couche 8 destinée à générer des porteurs d'un autre type que ceux de la couche 6, par exemple des trous.

Les couches de génération de porteurs 6 et 8 sont solidarisées à des contacts métalliques 9 et 10, respectivement raccordés aux bornes négative 3-2 et positive 3-1 de la diode. Une alternative consiste à solidariser le contact 9 au miroir 5 ou au substrat 4 (éventuellement par la face inférieure du substrat 4), lorsque le substrat 4 et le miroir 5 ont eux aussi la propriété de générer des porteurs. Comme cela est bien connu de l'homme de l'art, lorsque les contacts 9 et 10 présentent des polarisations opposées, choisies, les couches de génération de porteurs 6 et 8 produisent respectivement des électrons et des trous qui viennent se recombiner dans les moyens de conversion 7 en produisant des photons.

Préférentiellement, les moyens de conversion 7 sont réalisés sous la forme d'une structure à puits quantique(s) dont les caractéristiques sont choisies en fonction de la longueur d'onde que doivent présenter les photons émis par la diode.

Afin de permettre l'oxydation latérale des couches de GaAlAs du miroir de Bragg, l'empilement définissant le dispositif est entouré partiellement ou complètement par une ou plusieurs tranchées profondes 11 qui s'étendent de la couche 8 jusque dans le substrat 4.

Dans l'exemple illustré sur la figure 2, le contact 10 (positif) repose sur la surface supérieure de la couche de génération de trous 8, tandis que le contact 9 (négatif) repose sur la surface supérieure de la couche de génération d'électrons 6. Pour réaliser ce contact 9, on met à nu une partie de la couche de génération de trous 6 en définissant une mesa supérieur 12 dans les moyens de conversion 7 et la couche de génération de trous 8, par l'une des techniques de gravure (et/ou d'attaque sélective) connues de l'homme du métier. Préférentiellement, ces contacts sont réalisés sous la forme d'électrodes métalliques. Par ailleurs, le contact 9 entoure de préférence l'intégralité de la mesa 12.

Comme illustré sur la figure 2, seulement à titre d'exemple, la mesa 12 peut présenter une forme circulaire. Dans ce cas, le contact 9 est préférentiellement réalisé sous la forme d'un anneau entourant la mesa 12.

Bien entendu, la mesa pourrait présenter de nombreuses autres formes, comme par exemple une forme triangulaire, carrée ou rectangulaire.

On va maintenant décrire un exemple de combinaison de matériaux permettant de réaliser un dispositif électroluminescent selon l'invention.

Le dispositif comprend tout d'abord un substrat d'arséniure de gallium (GaAs) sur lequel est crû, par exemple par épitaxie par jets moléculaires, le miroir inférieur 5. Dans cet exemple, le miroir est réalisé d'abord sous la forme d'un empilement de couches semi-conductrices alternées de GaAs et AlGaAs. L'oxydation latérale qui est effectuée à partir des tranchées 11 transforme ensuite le GaAlAs en AlOx, définissant ainsi un miroir distribué de Bragg, très réfléchissant.

La couche de génération d'électrons 6 est préférentiellement réalisée dans un matériau semi-conducteur de type GaAs dopé n. Les moyens de conversion de paires électron/trou 7 (ou zone active) sont, par exemple, réalisés sous la forme d'un puits quantique d'InGaAs encadré par deux barrières d'AlGaAs. Enfin, la couche de génération de trous 8 est par exemple réalisée dans un matériau semi-conducteur tel que le GaAs dopé p.

Dans cet exemple, le miroir supérieur 14 est constitué par l'interface supérieure entre la couche de génération de trous 8, en GaAs dopé p, et l'air extérieur.

Le miroir inférieur 5 et le miroir supérieur 14 définissent, dans cet exemple non limitatif, une micro-cavité résonante, de type Fabry-Pérot, dans laquelle les photons produits dans le(s) puits quantique(s) selon des directions sensiblement perpendiculaires aux plans des miroirs supérieur et inférieur, sont transmis à l'extérieur, les autres demeurant confinés entre les miroirs, et notamment dans la couche constituant le(s) puits quantique(s) des moyens de conversion 7, sous forme d'un mode guidé.

Dans une variante, le miroir supérieur et le miroir inférieur pourraient définir une cavité anti-résonante, dans laquelle les photons produits dans les moyens de conversion 7 sont contraints à demeurer entre les miroirs (quasiment aucune lumière n'étant émise dans une direction sensiblement perpendiculaire aux plans des miroirs).

L'invention a pour but de récupérer tout ou partie des photons qui se trouvent confinés entre les miroirs dans les moyens de conversion 7 et les moyens de génération de porteurs 6 et 8, sous forme d'un mode guidé défini par les caractéristiques des moyens de conversion et des miroirs. Pour ce faire, elle propose des moyens d'extraction 13 qui vont être décrits maintenant.

Les moyens d'extraction de lumière 13 de l'invention communiquent avec les moyens de conversion 7 et les moyens de génération de porteurs 8 ainsi que de préférence 6. Comme illustré sur la figure 2, les moyens d'extraction 13 sont préférentiellement réalisés sous la forme d'une structuration tridimensionnelle diffractante d'une partie au moins des moyens de génération de porteurs (couches 6 et 8) et des moyens de conversion 7. Il est commode pour la fabrication que la structuration tridimensionnelle 13 débouche au niveau de la face supérieure de la couche de génération 8. Par ailleurs, il est préférable que la partie de la structuration qui est formée dans la couche de génération 8 soit totalement, ou au moins en grande partie séparée du reste de la couche de génération 8 qui est solidarisée au contact 10, notamment pour ne pas nuire à la conversion des paires de porteurs en photons. A cet effet, on peut réaliser dans l'intégralité de l'épaisseur de la couche de génération 8 (ou dans une fraction seulement de cette épaisseur) une tranchée 15, juste avant la zone de structuration 13.

Cette structuration 13 définit des éléments diffractants. Par conséquent, les dimensions de la structuration sont choisies de manière à vérifier les lois de l'optique ondulatoire. En d'autres termes, les dimensions caractéristiques de la structuration tridimensionnelle 13 sont typiquement de l'ordre de la longueur d'onde des photons « guidés ».

D'une façon particulièrement avantageuse, la structuration définit, sensiblement, un cristal ou quasi-cristal photonique de trous ou de colonnes de matériaux. Ces trous ou colonnes constituent les éléments diffractants qui vont permettre l'extraction, par diffraction, des photons guidés. Ils sont généralement fabriqués par un procédé de lithographie planaire, issu de la microélectronique et bien connu de l'homme de l'art. Le dispositif est d'abord recouvert d'une résine sensible qui est soumise localement (avec une résine positive, à l'endroit des trous que l'on veut graver) à un faisceau d'électrons ou de photons ultra-violet. La résine ainsi dégradée est retirée et les surfaces mises à nu subissent ensuite une attaque, chimique humide ou sèche par plasma, destinée à creuser les trous. Il existe une variété de techniques pour obtenir le résultat final, certaines faisant appel à des couches intermédiaires de type silice pour augmenter la profondeur de gravure, ou à l'utilisation de réseaux holographiques pour obtenir la modulation locale du faisceau de photons ultra-violet. Ces techniques sont également utilisables pour la réalisation d'autres parties du dispositif, comme les tranchées profondes 11 ou l'électrode 10. Une autre façon de fabriquer les structures diffractantes, particulièrement adaptée aux matériaux organiques, fait appel à l'embossage, à l'estampage ou au poinçonnage.

Les cristaux et quasi-cristaux photoniques étant des objets bien connus de l'homme du métier, leur mode de fonctionnement ne sera pas décrit ici en détail.

Le cristal ou quasi-cristal photonique est défini par un pavage qui peut prendre de très nombreuses formes. Il pourra s'agir d'un pavage définissant un réseau traditionnel présentant un niveau de symétrie inférieur ou égal à 6. Le motif du réseau pourra être par exemple un triangle équilatéral, un carré, ou un hexagone. Plus généralement, le pavage peut être constitué de tous types de polygones convexes sensiblement jointifs et partageant chacune de leurs arêtes avec un seul et unique voisin, dès lors que ces arêtes présentent sensiblement la même taille à environ ± 15%.

Cependant, afin d'augmenter encore le rendement d'extraction, il est préférable d'utiliser des pavages plus complexes, c'est-à-dire présentant des niveaux de symétrie supérieurs à 6. En effet, comme le sait l'homme de l'art, la diffraction est régie par la loi des réseaux. Selon cette loi, un photon présentant un vecteur d'onde incident *̅K̅*̅ i sera diffracté par un réseau, défini par le vecteur *̅G̅*̅ de son espace réciproque, si son vecteur d'onde final *̅K̅*̅ f suit la relation *̅K̅*̅f = *̅K̅*̅ i + *G̅.*

Par ailleurs, selon les lois de Snell-Descartes, le vecteur d'onde final des photons *̅K̅*̅ f est décomposable en une composante perpendiculaire *̅K̅*̅f┴ plus une composante parallèle *̅K̅*̅f//. Pour que le photon incident puisse sortir suivant une direction sensiblement perpendiculaire, il faut par conséquent que la composante parallèle de son vecteur d'onde final *̅K̅*̅f// soit très petite ou en d'autres termes que l'on ait la relation *̅K̅*̅ i + *̅G̅*̅ ≈ *̅O̅*̅. Dans ce cas, les photons vont pouvoir sortir, par diffraction, sensiblement perpendiculairement au plan dans lequel ils sont guidés.

Afin de pouvoir collecter le plus grand nombre possible de photons, il faut donc que le réseau réciproque soit défini par le plus grand nombre possible de vecteurs *̅G̅*̅ différents, mais de normes toutes sensiblement égales à celle de *̅K̅*̅ i, sans que ce nombre tende vers l'infini, ce qui correspondrait à un cas apériodique.

De tels "réseaux" présentent des niveaux de symétrie qui sont supérieurs à l'ordre 6. Dans une classe de réalisation proposée ci-dessous, ces réseaux possèdent une super-période qui est typiquement de l'ordre du micromètre, par exemple 2 µm. Pour satisfaire les fonctions d'extraction, ils n'ont besoin de s'étendre que sur un faible nombre de super-périodes, par exemple trois ou quatre super-périodes, en largeur.

Un certain nombre de pavages correspondent à ces caractéristiques. On peut citer, par exemple, les pavages d'Archimède formés à partir de triangles équilatéraux et de carrés dont les arêtes présentent toutes la même taille (comme illustré sur les figures 3A à 3C). On peut citer également les pavages de Penrose constitués à partir de deux types (premier et second) de losanges dont les angles au sommet diffèrent mais qui présentent des arêtes de même taille comme illustré sur la figure 3D.

De tels pavages peuvent être constitués de proportions sensiblement égales (ou comparables) de carrés et de triangles équilatéraux (voir figure 3A : réseau dit « carré » à quatre atomes par cellule unité), ou de premiers et seconds losanges. Mais ils peuvent également être construits par périodisation d'un motif comportant un nombre choisi de triangles équilatéraux et de carrés (comme illustré sur les figures 3C et 3D : réseaux dits « triangulaire réel » à sept et treize atomes par cellule unité, respectivement ; ils sont notamment décrits dans le document de S. David, A. Chelnokov et J.-M. Lourtioz, « Wide photonic bandgaps obtained from two-dimensional photonic crystals with Archimedean-like tiling », Optics letters, Vol. 25, Issue 14, pp. 1001-1003, Juillet 2000), ou de premiers et seconds losanges. Ils peuvent être encore construits par inflation de Stampfli d'un motif comportant un nombre choisi de triangles équilatéraux et de carrés (comme illustré sur la figure 3E et décrit notamment dans le document de M. Oxborrow et C. L. Henley, « Random square-triangle tilings : A model for twelvefold-symmetric quasicrystals », Phys. Rev. B, vol 48, Issue 10, pp. 6966-6998, 1993), ou de premiers et seconds losanges. Ils peuvent être également construits par une distribution sensiblement aléatoire de proportions choisies de triangles équilatéraux et de carrés (comme illustré sur la figure 3F), ou de premiers et seconds losanges.

Dans les structures de ce type, l'arrangement des premiers et seconds voisins d'un trou ou d'une colonne est très variable, mais les distances "interatomiques" entre eux restent sensiblement égales.

Bien entendu, les trous ou les colonnes peuvent être générés sur les arêtes du pavage ou sur ses noeuds, au choix.

Par ailleurs, il est préférable que la taille des arêtes du pavage soit sensiblement égale à une valeur moyenne choisie. Mais, cette taille pourra varier autour de cette valeur moyenne choisie dans un intervalle compris entre environ +15% et -15%. Ainsi, il est possible de partir d'un pavage qui s'étend sur une bande sensiblement rectangulaire (par exemple), et de tordre ce pavage, en particulier de le courber, de manière à ce qu'il s'étende sur une partie au moins d'une zone annulaire, ou sur la totalité d'une zone annulaire, comme illustré sur la figure 2.

Par ailleurs, le cristal photonique ou le quasi-cristal photonique pourra être réalisé sous la forme d'un pavage du type de ceux présentés ci-avant, mais dans lequel l'un au moins des éléments diffractants (trou ou colonne) est omis, de manière à former une structure de type amorphe (comme illustré sur la figure 3G).

En outre, dans le cas où la gravure perfore la couche de génération de porteurs 6 et que le miroir 5 est isolant, le matériau conducteur formant le cristal ou quasi-cristal photonique doit être connexe pour le courant électrique, de sorte que celui-ci puisse circuler entre les trous ou sous les colonnes.

Comme cela est illustré sur la figure 2, le cristal ou quasi-cristal photonique destiné à l'extraction des photons guidés, est préférentiellement réalisé à la périphérie de la zone dans laquelle sont produits les photons, par conversion de paires électron-trou.

A titre d'exemple illustratif, pour extraire des photons de longueur d'onde λ d'environ 1 µm, guidés dans un matériau d'indice optique n sensiblement égal à 3, la distance interatomique du pavage (λ/n) doit être comprise entre environ 300 nanomètres et 400 nanomètres. Par exemple, on peut réaliser des trous d'environ 150 nanomètres de diamètre et espacés les uns des autres d'environ 350 nanomètres. Par ailleurs, la profondeur des trous (ou la hauteur des colonnes) pourra varier selon l'épaisseur des couches utilisées pour former les moyens de conversion et les moyens de génération de porteurs. Typiquement, l'épaisseur ou la hauteur de ces éléments diffractants est de l'ordre de quelques centaines de nanomètres, par exemple 200 ou 300 nanomètres.

L'invention ne se limite pas aux modes de réalisation de dispositif décrits ci-avant, seulement à titre d'exemple, mais elle englobe toutes les variantes que pourra envisager l'homme de l'art dans le cadre des revendications ci-après.

En effet, la configuration du dispositif pourra être sensiblement inversée, la lumière sortant à travers la couche support (par exemple en cas de report). Dans ce cas, les moyens d'extraction peuvent néanmoins être gravés depuis la couche supérieure, le cas échéant au travers du miroir supérieur. Par exemple, on pourra utiliser un substrat non absorbant à la longueur d'onde choisie, sur lequel repose un miroir inférieur semi-réfléchissant, tandis que le miroir supérieur est très réfléchissant. On pcurra également reporter le dispositif sur un substrat transparent. Par ailleurs, les miroirs pourront être réalisés dans des matériaux métalliques, plutôt que semiconducteurs. En outre, d'autres types de matériaux semiconducteurs que ceux présentés ci-avant pourront être utilisés afin d'obtenir des longueurs d'onde différentes. Par exemple, pour obtenir une lumière rouge on pourra utiliser des alliages d'AlGaAs, ou d'AlGalnP, ainsi que des miroirs distribués d'AlOx, placés sur un substrat de GaAs. Dans ce cas les arêtes du pavage peuvent avoir des longueurs de l'ordre de 200 à 300 nm. Mais on pourra également utiliser d'autres types de matériaux que les semi-conducteurs, comme par exemple les matériaux organiques tels que les polymères organiques, conjugués ou non, et les complexes organométalliques.

## Revendications

1. Dispositif électroluminescent (1), comprenant un miroir inférieur (5) et un miroir supérieur (14) sensiblement parallèles qui encadrent des moyens (7) de conversion de paires électron-trou en photons formant une zone active et des moyens (6,8) de génération d'électrons et de trous
lesdits, moyens de conversion de paires electron-trou en photons (7) et les miroirs (5,14) étant agencés de manière à assurer le confinement entre lesdits miroirs (5, 14) des photons présentant au moins une longueur d'onde choisie associée à un mode de propagation guidé,
le dispositif comprenant en outre des moyens d'extraction de lumière à cristaux photoniques (13) pour extraire une partie au moins des photons dans le mode guidé,
les moyens de génération d'électrons et de trous (6,8) comprennent une couche inférieure (6) de génération d'électrons ou de trous reliée à un premier contact électrique (9) et intercalée entre le miroir inférieur (5) et les moyens de conversion de paires électron-trou en photons (7), et une couche supérieure (8) de génération de trous ou d'électrons, reliée à un second contact électrique (10) et disposée sur les moyens de conversion de paires électron-trou en photons (7) **caractérisé en ce que** une mesa supérieure (12) est défini dans les moyens de conversion de paires électron-trou en photons (7) et la couche supérieure de génération d'électrons et de trous (8), **en ce que**
les moyens d'extraction de lumière (13) sont réalisés dans une partie de ladite mesa (12), sous la forme d'un quasi-cristal photonique de trous ou de colonnes constituant des éléments diffractants, présentant des dimensions de l'ordre de la longueur d'onde es photons dans le mode guidé, ces trous ou colonnes s'étendant depuis face supérieure de la couche supérieure de génération d'électron et de trous (8) jusqu'à la couche inférieure de génération d'électron et de trous (6), et
la partie de la couche supérieure de génération d'électron et de trous (8) dans laquelle sont formés les trous ou colonnes du quasi-cristal photonique (13) étant séparée du reste de cette couche supérieure de génération d'électron et de trous (8) par une tranchée (15) formée dans au moins une fraction de l'épaisseur de ladite couche supérieure de génération d'électron et de trous (8) pour ne pas nuire à la conversion des paires électron-trou en photons.

2. Dispositif selon la revendication 1, **caractérisé en ce que** ledit quasi-cristal est un pavage de polygones convexes sensiblement jointifs et partageant chacune de leurs arêtes avec un unique voisin, ladite taille des arêtes étant sensiblement égale à une valeur moyenne choisie, à un pourcentage près compris entre environ +15% et-15%.

3. Dispositif selon la revendication 2, **caractérisé en ce que** ledit pavage est constitué de proportions sensiblement égales de carrés et de triangles équilatéraux, ou de premiers et seconds losanges d'angles aux sommets différents, d'arêtes de tailles sensiblement égales.

4. Dispositif selon la revendication 2, **caractérisé en ce que** ledit pavage est construit par périodisation d'un motif comportant un nombre choisi de triangles équilatéraux et de carrés, ou de premiers et seconds losanges d'angles aux sommets différents.

5. Dispositif selon la revendication 2, **caractérisé en ce que** ledit pavage est construit par inflation de Stampfli d'un motif comportant un nombre choisi de triangles équilatéraux et de carrés, ou de premiers et seconds losanges d'angles aux sommets différents.

6. Dispositif selon la revendication 2, **caractérisé en ce que** ledit pavage est construit par une distribution sensiblement aléatoire de proportions choisies de triangles équilatéraux et de carrés, ou de premiers et seconds losanges d'angles aux sommets différents.

7. Dispositif selon l'une des revendications 2 à 6, **caractérisé en ce que** ledit pavage est tordu de manière à entourer au moins partie lesdits moyens de génération d'électrons et de trous (6,8) et lesdits moyens de conversion de paires electron-trou en photons (7).

8. Dispositif selon l'une des revendications 2 à 7, **caractérisé en ce que** ledit pavage est courbé de manière à s'étendre sur au moins une partie d'une zone annulaire.

9. Dispositif selon l'une des revendications 2 à 8, **caractérisé en ce que** ledit quasi-cristal est un pavage dans lequel l'un au moins des éléments diffractants est omis.

10. Dispositif selon l'une des revendications 1 à 9, **caractérisé en ce que** le miroir supérieur (14) est de type semi-réfléchissant et constitué par une interface entre la couche supérieure de génération d'électrons et de trous (8) et une couche d'un autre matériau.

11. Dispositif selon la revendication 10, **caractérisé en ce que** ledit autre matériau est choisi dans un groupe comprenant l'air, l'époxy et un matériau formant substrat.

12. Dispositif selon l'une des revendications 1 à 11, **caractérisé en ce que** le miroir inférieur (5) est un miroir réfléchissant, de type miroir de Bragg, placé sur un substrat.

13. Dispositif selon l'une des revendications 1 à 12, **caractérisé en ce que** les moyens de conversion de paires electron trou en photons (7) et une partie des couches inférieure et supérieure de génération d'électrons et de trous (6,8) sont constitués de matériaux choisis dans un groupe comprenant les semiconducteurs et les matériaux organiques électroluminescents.

14. Dispositif selon la revendication 13, **caractérisé en ce que** lesdits matériaux organiques sont choisis dans un groupe comprenant les polymères organiques, conjugués ou non, et les complexes organométalliques.

15. Dispositif selon la revendication 13, **caractérisé en ce que** lesdits semiconducteurs sont choisis dans un groupe comprenant le silicium, les composés à base de gallium, d'aluminium, d'indium, d'azote, de phosphore, d'arsenic et d'antimoine, ainsi que leurs alliages.

16. Dispositif selon l'une des revendications 13 et 15, **caractérisé en ce qu'**il est constitué i) d'un empilement ordonné d'un substrat de GaAs (4), d'une alternance de couches de GaAs et d'AlAs formant ledit miroir inférieur (5), d'une couche inférieure de Gazas dopée n (6), d'une zone active (7) constituée de deux barrières d'AlGaAs encadrant un puits quantique en InGaAs et formant lesdits moyens de conversion, d'une couche supérieure de GaAs dopée n (8) formant ledit miroir supérieur (14) avec une couche d'air extérieur, et ii) d'un premier contact électrique (10) propre à placer la couche de GaAs dopée p (8) sous une polarisation positive et d'un second contact électrique (9) propre à placer la couche de GaAs dopée n (6) sous une polarisation négative.

17. Dispositif selon l'une des revendications 1 à 16, **caractérisé en ce que** les miroirs définissent une cavité résonante asymétrique, en particulier de type Fabry-Pérot.

18. Diode électroluminescente, **caractérisée en ce qu'**elle comporte un dispositif (1) selon l'une des revendications précédentes.

## Claims

1. An electroluminescent device (1) comprising a lower mirror (5) and a upper mirror (14) substantially parallel and framing converting means (7) for converting electron-hole pairs into photons forming an active area, and electron and holes generating means (6,8),
said means (7) for converting electron-hole pairs into photons and the mirrors (5, 14) being arranged so as to ensure containment between said mirrors (5, 14) of photons presenting at least a selected wavelength associated to a guided propagation mode,
said device also comprising photonic crystals light extraction means (13) for extracting at least a part of the photons in the guided mode,
said electron and holes generating means (6,8) comprising a lower layer (6) for generating electrons or holes linked to a first electrical contact (9) and interposed between the lower mirror (5) and the means (7) for converting electron-hole pairs into photons (7), and a upper layer (8) for generating holes or electrons, linked to a second electrical contact (10) and arranged on the means (7) for converting electron-hole pairs into photons,
**characterised in that** an upper mesa (12) is defined in the means (7) for converting electron-hole pairs into photons and the upper layer (8) for generating electrons and holes, and **in that**
said light extracting means (13) are realised in a part of said mesa (12), in the form of a photonic quasi-crystal of holes or columns constituting diffracting elements, with dimensions of about the wavelength of photons in the guided mode, said holes or columns extending from the upper surface of the upper layer (8) for generating electrons and holes to the lower layer for generating electrons and holes (6), and
said part of the upper layer (8) for generating electrons and holes in which are formed the holes or columns of the photonic quasi-crystal (13) being separated of the rest of this upper layer (8) for generating electrons and holes by a trench (15) formed into at least a portion of the thickness of said upper layer (8) for generating electrons and holes in order to avoid interference with the conversion of electron-hole pairs into photons.

2. A device according to claim 1, **characterised in that** said quasi-crystal is a tiling of convex substantially jointed polygons and sharing each of their edges with an unique neighbour, said size of the edges being substantially equal to a selected average value, with a percentage close to within approximately +15% and -15%.

3. A device according to claim 2, **characterised in that** said tiling is constituted of substantially equal proportions of squares and equilateral triangles, or of first and second angular rhombs with different apexes, with substantially equal-sized edges.

4. A device according to claim 2, **characterised in that** said tiling is constructed by periodisation of a pattern including a selected number of equilateral triangles and squares, or first and second angular rhombs with different apexes.

5. A device according to claim 2, **characterised in that** said tiling is constructed by Stampfli inflation of a pattern comprising a selected number of equilateral triangles and squares, or first and second angular rhombs with different apexes.

6. A device according to claim 2, **characterised in that** said tiling is constructed by a substantially random distribution of selected proportions of equilateral triangles and squares, or of first and seconds angular rhombs with different apexes.

7. A device according to one of claims 2 to 6, **characterised in that** said tiling is twisted so as to surround at least partly said electron and holes generating means (6,8) and said means (7) for converting electron-hole pairs into photons (7).

8. A device according to one of the claims 2 to 7, **characterised in that** said tiling is curved so that it can extend over at least a part of an annular area.

9. A device according to one of claims 2 to 8, **characterised in that** said quasi-crystal is a tiling in which at least one of the diffracting elements is omitted.

10. A device according to one of the claims 1 to 9, **characterised in that** the upper mirror (14) is of the semi-reflective type and constituted by an interface between the upper layer (8) for generating electrons and holes and a layer of another material.

11. A device according to claim 10, **characterised in that** said other material is selected from a group comprising air, epoxy and a material forming the substrate.

12. A device according to one of the claims 1 to 11, **characterised in that** the lower mirror (5) is a reflective mirror of the Bragg's mirror type placed on a substrate.

13. A device according to one of the claims 1 to 12, **characterised in that** the means (7) for converting electron-hole pairs into photons and a part of the lower and upper layers (6,8) for generating electrons and holes are constituted of materials selected from a group comprising semiconductors and organic electroluminescent materials.

14. A device according to claim 13, **characterised in that** said organic materials are selected from a group comprising organic polymers, conjugated or not, and organometallic complexes.

15. A device according to claim 13, **characterised in that** said semiconductors are selected from a group comprising silicon, gallium-, aluminium-, indium-, nitrogen-, phosphorus-, arsenic- and antimony-based compounds, as well as their alloys.

16. A device according to one of claims 13 and 15, **characterised in that** it is constituted i) of an ordered stacking of GaAs substrate (4), alternating layers of GaAs and AlAs forming said lower mirror (5), a n doped lower GaAs layer (6), an active layer (7) constituted of two AlGaAs barriers framing a quantic well in InGaAs and forming said converting means, a n doped upper GaAs layer (8) forming said upper mirror (14) with a layer of outer air, and ii) of a first means of electric contact (10) to enable the p doped GaAs layer (8) to be placed under a positive polarisation and a second means of electric contact (9) suitable to place the n doped GaAs layer (6) to be placed under a negative polarisation.

17. A device according to one of claims 1 to 16. **characterised in that** the mirrors define an asymmetric magnetogenic cavity, in particular of the Fabry-Pérot type.

18. An electroluminescent diode, **characterised in that** it comprises a device (1) according to one of the previous claims.

## Patentansprüche

1. Elektrolumineszente Vorrichtung (1), umfassend einen unteren Spiegel (5) und einen oberen Spiegel (14), die etwa parallel sind, und welche Mittel (7) zur Umwandlung von Loch-Elektronen-Paaren in Photonen unter Ausbildung einer aktiven Zone und Mittel (6, 8) zur Erzeugung von Elektronen und Löchern umrahmen,
wobei die Mittel zur Umwandlung von Loch-Eletkronen-Paaren in Photone (7) und die Spiegel (5, 14) derart angeordnet sind, dass die Isolierung zwischen den Spiegeln (5, 14) von Photonen von wenigstens einer ausgewählten Wellenlänge, verbunden mit einem zwangsgeführten Fortpflanzungsmodus, sicherzustellen,
wobei die Vorrichtung des Weiteren Lichtextraktionsmittel mit Photonenkristallen (13) zum Extrahieren eines Teils wenigstens der Photonen im zwangsgeführten Modus umfasst,
die Mittel zur Erzeugung von Elektronen und Löchern (6, 8) eine untere Schicht (6) zur Erzeugung von Elektronen oder Löchern, verknüpft mit einem ersten elektrischen Kontakt (9), angeordnet zwischen dem unteren Spiegel (5) und den Mitteln zur Umwandlung (7) von Loch-Elektronen-Paaren in Photonen, und eine obere Schicht (8) zur Erzeugung von Löchern und Elektronen, verknüpft mit einem zweiten elektrischen Kontakt (10) und angeordnet auf dem Mittel zur Umwandlung (7) von Loch-Elektronen-Paaren in Photonen, umfassen, eine obere Tafel (12) in dem Mittel zur Umwandlung (7) der Loch-Elektronen-Paare in Photonen und der oberen Schicht (8) zur Erzeugung von Elektronen und Löchern definiert ist und **dadurch**, dass
die Mittel zur Lichtextraktion (13) in einem Teil der Tafel (12) verwirklicht sind, in Form eines Quasi-Photonenkristalls Beugungselemente bildenden Löchern oder Kolonnen, die Größenordnungen der Photonenwellenlänge im zwangsgeführten Modus darstellen, wobei sich die Löcher oder die Kolonnen von der Oberfläche der oberen Schicht zur Erzeugung von Elektronen und Löchern (8) bis zur unteren Schicht der Erzeugung von Elektronen und Löchern (6) erstrecken und
der Teil der oberen Schicht zur Erzeugung von Elektronen und Löchern (8), in welchem die Löcher oder Kolonnen des Quasi-Photonenkristalls (13) ausgebildet sind, vom Rest dieser oberen Schicht zur Erzeugung von Elektronen und Löchern (8) durch eine Fuge (15) separiert sind, die wenigstens in einem Teil der Dicke dieser oberen Schicht zur Erzeugung von Elektronen und Löchern (8) gebildet ist, um die Umwandlung der Loch-Elektronen-Paare in Photonen nicht zu behindern.

2. Vorrichtung nach Anspruch 1, **dadurch gekennzeichnet, dass** der Quasi-Kristall ein Pflaster von aneinandergesetzten konvexen Polygonen ist, welche jede ihrer Kanten mit einem einzigen Nachbarn teilen, wobei die Größe der Kanten etwa gleich einem Mittelwert ist, mit einem Prozentsatz zwischen etwa +15% und -15%.

3. Vorrichtung gemäß Anspruch 2, **dadurch gekennzeichnet, dass** das Pflaster aus etwa gleichen Proportionen von Quadraten und gleichseitigen Dreiecken oder aus ersten und zweiten Rhomben mit an der Spitze verschiedenen Winkeln und Kanten etwa gleicher Größe gebildet ist.

4. Vorrichtung nach Anspruch 2, **dadurch gekennzeichnet, dass** das Pflaster durch Periodisieren eines Motivs gebildet ist, das eine ausgewählte Anzahl von gleichseitigen Dreiecken und Quadraten oder erste und zweite Rhomben mit an der Spitze verschiedenen Winkeln aufweist.

5. Vorrichtung nach Anspruch 2, **dadurch gekennzeichnet, dass** das Pflaster durch Stampfli-Inflation eines Motivs konstruiert ist, das eine ausgewählte Anzahl von gleichseitigen Dreiecken und Quadraten oder erste und zweite Rhomben mit an der Spitze unterschiedlichen Winkeln aufweist.

6. Vorrichtung nach Anspruch 2, **dadurch gekennzeichnet, dass** das Pflaster durch eine etwa zufällige Verteilung von ausgewählten Proportionen von gleichseitigen Dreiecken und Quadraten oder ersten und zweiten Rhomben mit an den Spitzen unterschiedlichen Winkeln konstruiert ist.

7. Vorrichtung nach einem der Ansprüche 2 bis 6, **dadurch gekennzeichnet, dass** das Pflaster derart gekrümmt ist, dass es wenigstens einen Teil der Mittel zur Erzeugung von Elektronen und Löchern (6, 8) und der Mittel der Umwandlung von Loch-Elektronen-Paaren in Photone einschließt.

8. Vorrichtung gemäß einem der Ansprüche 2 bis 7, **dadurch gekennzeichnet, dass** das Pflaster so gekrümmt ist, dass es sich über wenigstens einen Teil eines ringförmigen Bereichs erstreckt.

9. Vorrichtung gemäß einem der Ansprüche 2 bis 8, **dadurch gekennzeichnet, dass** der Quasi-Kristall ein Pflaster ist, worin eines wenigstens der Beugungselemente weggelassen ist.

10. Vorrichtung gemäß einem der Ansprüche 1 bis 9, **dadurch gekennzeichnet, dass** der obere Spiegel (14) vom halbreflektierenden Typ ist und durch eine Schnittstelle zwischen der oberen Schicht zur Erzeugung von Elektronen und Löchern (8) und einer Schicht aus einem anderen Material gebildet ist.

11. Vorrichtung gemäß Anspruch 10, **dadurch gekennzeichnet, dass** das andere Material aus einer Gruppe ausgewählt ist, umfassend Luft, Epoxid und ein Material, das ein Substrat bildet.

12. Vorrichtung gemäß einem der Ansprüche 1 bis 11, **dadurch gekennzeichnet, dass** der untere Spiegel (5) ein reflektierender Spiegel vom Typ Bragg-Spiegel ist, der auf einem Substrat angeordnet ist.

13. Vorrichtung gemäß einem der Ansprüche 1 bis 12, **dadurch gekennzeichnet, dass** die Mittel zur Umwandlung von Loch-Elektronen-Paaren in Photone (7) und ein Teil der unteren und oberen Schichten zur Erzeugung von Elektronen und Löchern (6, 8) aus einem Material gebildet sind, das aus einer Gruppe ausgewählt ist, die Halbleiter und elektrolumineszente organische Materialien umfasst.

14. Vorrichtung gemäß Anspruch 13, **dadurch gekennzeichnet, dass** die organischen Materialien aus einer Gruppe ausgewählt sind, umfassend konjugierte oder nicht-konjugierte organische Polymere und Organometallkomplexe.

15. Vorrichtung gemäß Anspruch 13, **dadurch gekennzeichnet, dass** die Halbleiter aus einer Gruppe ausgewählt sind, umfassend Silicium, auf Gallium, Aluminium, Indium, Stickstoff, Phosphor, Arsen und Antimon basierende Verbindungen sowie ihre Legierungen.

16. Vorrichtung gemäß einem der Ansprüche 13 und 15, **dadurch gekennzeichnet, dass** sie aus i) einer Packung, geordnet aus einem GaAs-Substrat (4), mit einem Wechsel von GaAs und AlAs-Schichten, welche den unteren Spiegel (5) bilden, einer unteren n-dotierten GaAs-Schicht (6), einer aktiven Zone (7), gebildet aus zwei AlGaAs-Barrieren, die einen Quantenbrunnen aus InGaAs unter Bildung der Umwandlungsmittel umrahmen, einer oberen n-dotierten GaAs-Schicht (8), welche den oberen Spiegel (14) mit einer äußeren Luftschicht bildet und ii) einem ersten elektrischen Kontakt (10), der dazu geeignet ist, die p-dotierte GaAs-Schicht (8) in eine positive Polarisation zu bringen und einem zweiten elektrischen Kontakt (9), der dazu geeignet ist, die n-dotierte GaAs-Schicht (6) in eine negative Polarisation zu bringen, aufgebaut ist.

17. Vorrichtung gemäß einem der Ansprüche 1 bis 16, **dadurch gekennzeichnet, dass** die Spiegel einen asymmetrischen Resonanzraum definieren, insbesondere vom Typ Fabry-Perot.

18. Elektrolumineszente Diode, **dadurch gekennzeichnet, dass** sie eine Vorrichtung (1) gemäß einem der vorangehenden Patentansprüche aufweist.
